# EUROPEAN PATENT SPECIFICATION

(11) **EP 1 577 941 B1**
(45) Date of publication and mention of the grant of the patent: **08.04.2015**
(21) Application number: 05003847.0
(22) Date of filing: 23.02.2005
(51) Int. Cl.: H01L 21/768, H01L 21/033, H01L 21/311

(54) **Method for creating a pattern in a material and semiconductor structure processed therewith**
Verfahren zur Erzeugung einer Struktur in einem Material und auf diese Weise hergestellte Halbleiterstruktur
Procédé pour la création d'un motif dans un matériau et structure semiconductrice fabriqué de cette manière

(30) Priority: 16.03.2004 EP 04101072
(43) Date of publication of application: 21.09.2005
(73) Proprietor: IMEC, 3001 Leuven (BE); NXP B.V., 5656 AG Eindhoven (NL)
(72) Inventor: Verheijden, Greja Johanna Adriana Maria, 5551 AT Valkenswaard (NL); Bancken, Pascal Henri Leon, 6024 BJ Budel Dorplein (NL); Van Wingerden, Johannes, 3373 AL Hardinsveld-Giessendam (NL)
(74) Representative: Bird, Ariane

(56) References cited:
- JP-A- 5 343 279
- JP-A- 2000 223 490
- US-A1- 2003 003 401
- US-B1- 6 605 541
- DATABASE WPI Week 199638 Derwent Publications Ltd., London, GB; AN 1996-382352 XP002418443 & KR 940 010 508 B1 (SAMSUNG ELECTRONICS CO LTD) 24 October 1994 (1994-10-24)

## Description

The invention relates to a method of manufacturing a semiconductor device wherein a pattern is created in a material, the method comprising covering the material with a lower mask layer and covering the lower mask layer with an upper mask layer, creating a first pattern on the upper mask layer by means of a lithographic mask and removing a part of the upper mask layer in dependency on the first pattern. Further, the invention relates to a semiconductor structure processed with the method according to the invention.

Patent Abstracts of Japan, 2000-223490 describes the manufacture of a semiconductor device. On a silicon oxide film, an organic layer is formed. The organic layer is then covered by two stacked inorganic masks, such that the lower inorganic mask protects the organic layer while removing resist.

US6605541 provides a method for defining features in a conductor layer with a dimension of half the minimum pitch. After patterning a mask layer, a photoresist is applied with a pattern shifted with respect to the mask layer. The underlying conductor layer is then etched through the combined pattern of photoresist and mask layer. Thereafter, portions of the mask layer that are exposed through the photoresist are etched. A planarizing spin-on layer is then applied over the patterned conductor layer. The mask layer is then removed to expose underlying portions of the conductor layer. These portions are then etched selectively to the planarizing layer. Finally, the spin-on layer is removed again, resulting in conductor patterns of half the minimum pitch.

A problem associated with the prior art is that dimensions in microcircuits, such as integrated circuits, are becoming smaller and smaller. Dimensions of patterns defined in such materials, or other materials, are however limited by a resolution of an imaging system for applying the pattern on the material. Thus, dimensions of structures such as trenches and IMD are limited by a resolution of the imaging system.

A goal of the invention is to enable providing structures having smaller dimensions.

To achieve this goal, the invention provides the methods as specified in the claims.

First, the upper mask layer is patterned in accordance with the lithographical mask. Then, the mask is displaced over a distance, and a second pattern is created which is thus identical to the first pattern but displaced over said distance with respect to the first pattern. The second pattern is provided on the upper mask layer or on the lower mask layer at the locations where the upper mask layer has been removed in dependency on the first pattern. Next, in accordance with at least the second pattern, a part of the lower mask layer and/or the upper mask layer is removed. As a result, a mask is created by the remaining parts of the lower mask layer and the upper mask layer. A resolution of this resulting mask is exclusively determined by the resolution of the imaging system which projects the lithographic mask on the respective layer. Due to the displacement however, structures can be created with a resolution determined mainly by the accuracy of the displacement. Due to the displacement of the mask, and thus due to the displacement of the second pattern with respect to the first pattern, resulting structures having a small dimension, and thus a high resolution, can be created. As a next step, a part of the material is removed in accordance with a mask formed by the remaining parts of the lower and upper mask layers.

The method can be applied to create small structures, e.g. small trenches, and to this end, in an advantageous embodiment the step of removing a part of the lower mask layer and/or the upper mask layer in accordance with at least the second pattern comprises removing a part of the lower mask layer in accordance with the second pattern overlaid with a pattern formed by a remaining part of the upper mask layer. After removing a part of the upper mask layer in dependency on the first pattern, a part of the lower mask layer is not covered anymore by the upper mask layer. In accordance with the displaced pattern, now a part of the uncovered lower mask layer is removed effectively in accordance with a pattern formed by the second pattern overlaid with the remaining part of the upper mask layer, i.e. the remaining part of the upper mask layer after removal of a part of the upper mask layer in dependency on the first pattern. As a next step, a part of the underlying material can be removed with the resulting mask formed by the remaining parts of the lower and the upper mask layers. Due to the removal of the smaller part of the lower mask layer, small structures, such as small trenches or other openings can be created in the material.

Alternatively, or in addition thereto, it is possible with the method according to the invention to create small remaining parts, e.g. small spacings in the material, and to this end, in an advantageous embodiment the step of removing a part of the lower mask layer and/or the upper mask layer in accordance with at least the second pattern comprises removing a part of the upper mask layer in accordance with the second pattern, and removing a part of the lower mask layer in accordance with a pattern formed by the upper mask layer. Thus, following the removal of a part of the upper mask layer in dependency on the first pattern, a part of the upper mask layer is removed in dependency on the second pattern. As a result, small structures, e.g. small spacings of the upper mask layer remain, the dimension of which is determined by the original width of the pattern as determined by the mask and by the displacement of the second pattern with respect to the first pattern. Then, a part of the lower mask layer is removed in dependency on the pattern formed by the upper mask layer, followed by the removal of the underlying material. As a result, a small spacing of underlying material remains, the dimension of which is essentially determined by the displacement of the second pattern with respect to the first pattern and the original width of the pattern.

Advantageously, the removal of a part of any of the mask layers, i.e. the lower mask layer and/or the upper mask layer, is performed by selective etching of the respective layer in accordance with the respective pattern. As a result, only the respective layer, i.e. the upper mask layer or the lower mask layer is etched, and not the other one of the mask layers.

The material can comprise an organic and/or an inorganic material. For inorganic materials, such as inorganic dielectric materials, it is difficult to achieve a good selectivity towards the mask layers. To solve this problem, in an advantageous embodiment, the material comprises a layer of organic material covering a layer of inorganic material. The removal of a part of the material in accordance with a mask formed by the remaining parts of the lower and the upper mask layers comprises removing a part of the organic material in accordance with the mask formed by remaining parts of the lower and the upper mask layers, removing a part of the inorganic material in accordance with the mask formed by a remaining part of at least the organic material, and removing the remaining part of the organic material. Thus, the organic material is patterned in accordance with the steps as described above, and then a part of the inorganic material is removed using the remaining part of the organic material as a mask, and the remaining part of the organic material can be removed, after which the desired pattern in the organic material results.

In any of the embodiments described above, the method advantageously comprises the further step of removing the remaining parts of the lower and the upper mask layers. The layers can be removed by any suitable removal technique, such as wet or dry etching, chemical mechanical polishing.

Further advantages and features of the invention will now be described with reference to the drawing, in which non-limiting embodiments of the invention are shown, in which:
Figs. 1a to 1d show a cross-sectional view of mask layers and layers of material in which a patterning scheme according to the invention is shown;
Figs. 2a to 2d also show a cross-sectional view of mask layers and layers of material, showing steps for the creation of a small trench in succession to the steps according to Fig. 1; and
Figs. 3a to 3f show a cross-sectional view of mask layers and material layers, showing steps leading to the creation of a small spacing in succession to the steps according to Fig. 1.

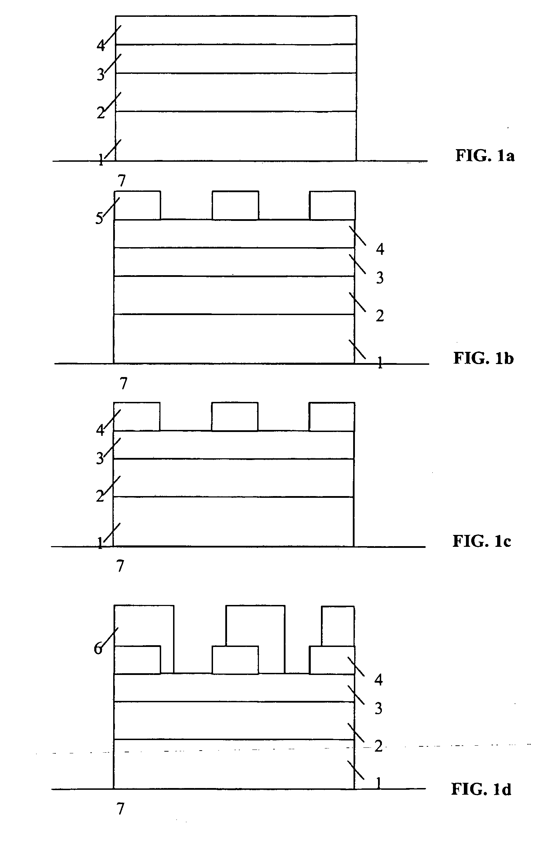

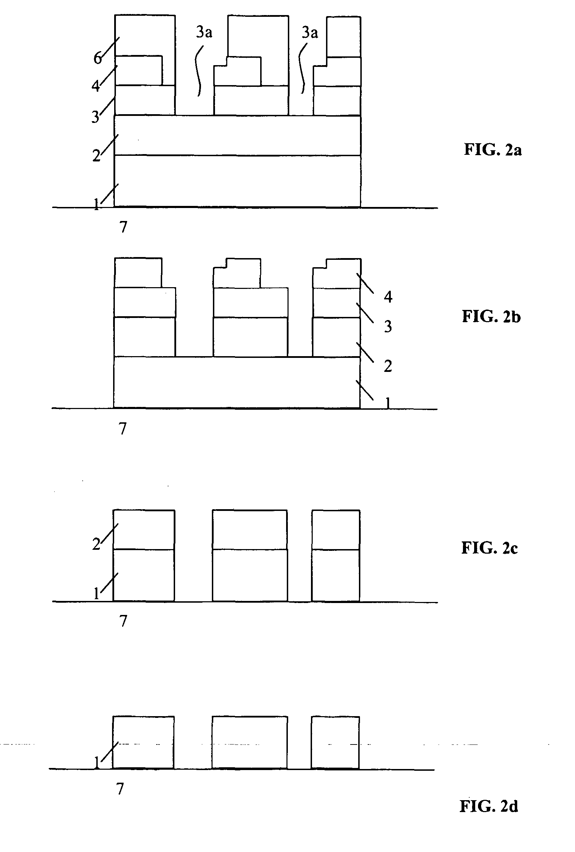

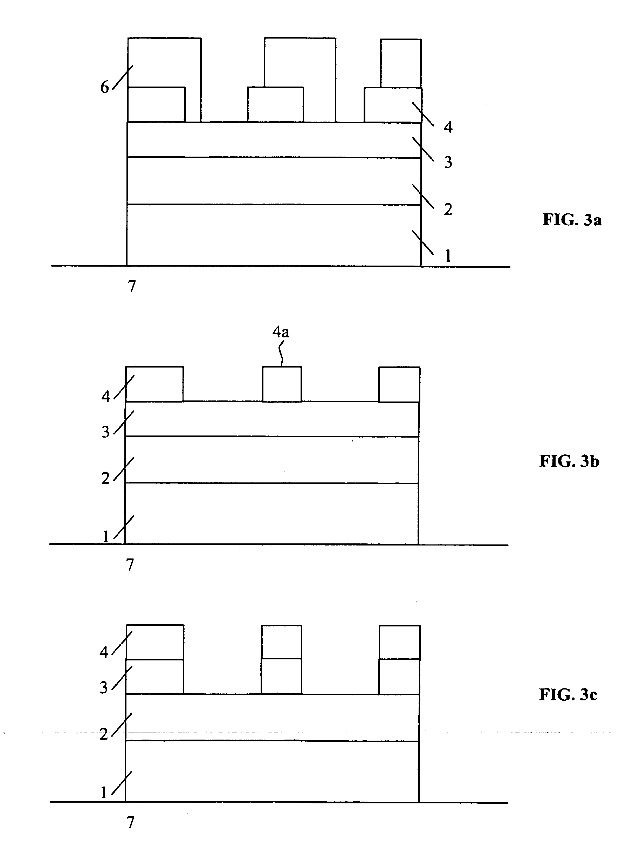

Figs. 1a-1d show a cross-sectional view of a (part of a) semiconductor structure comprising an inorganic dielectric 1 formed upon a substrate 7. This substrate can be a conductive or semiconductive substrate such as silicon, germanium, silicon-on-insulator. It can be a non-conductive substrate such as a ceramic plate, a quartz plate, a thin film substrate. On top of the inorganic dielectric a layer of organic material 2 is provided. The layer of organic material 2 in turn is covered by a lower mask layer, indicated in the Figures as hard mask 3 (inorganic), which in turn is covered by an upper mask layer, indicated in the Figures as hard mask 4 (inorganic). The inorganic material is the layer that needs to be patterned and the other layers shown are sacrificial layers used in the process. On top of the structure, a layer of resist 5 is applied and, as shown in Fig. 1b, a pattern is transferred into the resist 5, e.g. by means of a standard lithography step. As shown in Fig. 1c, the pattern is now etched into the upper mask layer 4 by using an etch recipe that is selective towards the lower mask layer, i.e. only etches the upper mask layer 4 and does not etch the lower mask layer 3. Then, the resist 5 is stripped, the result of which is shown in Fig. 1c. Next, a new layer of resist 6 is provided on top of the structure and the pattern is again transferred into the resist 6, and the applicable portions of the resist 6 are removed in dependency on the pattern, in a way similar to the pattern as shown with reference to Fig. 1b, however the second pattern as shown with reference to Fig. 1d is displaced over a distance with respect to the earlier (i.e. the first) pattern as shown with reference to Fig. 1b. The pattern in the resist 6 in Fig. 1d creates a pattern on the upper mask layer 4, where present, and on the lower mask layer 3 at locations where the upper mask layer 4 has been removed. Once arrived at the stage depicted in Fig. 1d, two different approaches can be used, one for the creation of a small trench, and the other for the creation of a small spacing. The further steps for the creation of a small trench are shown with reference to Figs. 2a-2d, while the further steps for the creation of a small spacing are shown with reference to Figs. 3a-3d. In both cases, the further steps comprise the removal of a part of the lower mask layer and/or the upper mask layer in accordance with at least the second pattern, and the removal of a part of the material, i.e. the organic or inorganic layer, in accordance with a mask formed by remaining parts of the lower and upper mask layers.

As shown in Fig. 2a, starting from the situation as shown in Fig. 1d, as a next step the part of the lower mask layer 3 is etched with an etch recipe that is selective towards the upper mask layer 4, and thus does not affect the organic material 2 or the upper mask layer 4. As a result, small trenches are created in the lower mask layer 3, the trenches being indicated by 3a. The small trenches 3a in the lower mask layer 3 have a width that consists only of the overlapping exposed parts of the first pattern and the second pattern. Thus, the dimension (in this example the width) of the trench 3a is reduced as compared to the width of the opening in the first pattern, such as e.g. in the resist 5 and the upper mask layer 4, or in the second pattern, such as e.g. in the resist 6. As a next step, as shown with reference to Fig. 2b, the organic material 2 is etched thereby also removing the resist 6. Due to the small dimensions of the trench 3a in the lower mask layer 3, the trenches in the organic material 2 will also have the same or substantially the same small dimension. Next, as shown with reference to Fig. 2c, the pattern as present in the organic material 2 is etched into the inorganic dielectric 1, and subsequently the two hard masks 3, 4 are removed. Finally, also the organic material 2 will be removed, as shown in Fig. 2d.

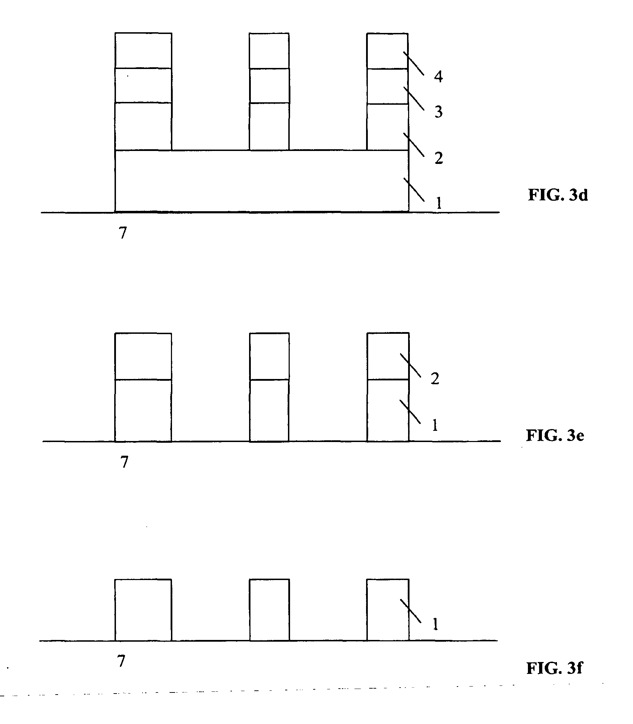

Now, starting from the situation as shown in Fig. 1d, further steps for creating a small spacing will be shown with reference to Figs. 3a-3f. After having performed the steps as described with reference to Figs. 1a-1d, as a next step, as shown with reference to Fig. 3a, the upper mask layer 4 is again selectively etched with the second pattern as formed in the resist 6. Then the resist 6 is removed, e.g. stripped afterwards, as shown in Fig. 3b. As a result, a spacing 4a is created, of which the dimension is smaller than the dimension obtainable with the resolution of the first pattern and the second pattern. It is remarked that the selective etching of the upper mask layer 4 is to be interpreted as an etching operation which (substantially) does not affect the lower mask layer 3, and vice versa. Next, the lower mask layer 3 is etched selectively, without affecting the upper mask layer 4, the result of which is shown in Fig. 3c. As a result, the spacing 4a now defined in the upper mask layer 4 and the lower mask layer 3 consists only of the overlapping parts of the two patterns. Thus, the dimensions of the spacing 4a are reduced as compared to the spacing of the first and second pattern. Then, the pattern in the lower mask layer 3 and/or upper mask layer 4 is used as a mask to etch the organic layer 2, the result of which is shown in Fig. 3d. Following this step, the pattern now present in the organic layer 2 is used as a mask for the inorganic layer 1 when etching the inorganic layer 1. In this etching step, also the lower mask layer 3 and upper mask layer 4 are etched, the result of which is shown in Fig. 3e. Finally, the inorganic material 2 is removed, for example stripped.

Although in Figs. 1-3 only a one-dimensional example has been shown in which a displacement of the second pattern with regard to the first pattern is a one-dimensional displacement, it will be appreciated by the skilled person that the mask can also be displaced such that the second pattern is displaced in two dimensions in a plane of the layer of materials. Thus, structures having a small dimension can be achieved in two dimensions in the plane of the material layers with one sequence of process steps as described with reference to Fig. 1 and Fig. 2 or with reference to Fig. 1 and Fig. 3. Further, as the displacement of the second pattern with reference to the first pattern can be small, and the displacement determines the smallest dimensions that can be obtained in the layers, there is no fundamental limit to the smallest dimensions that can be obtained with the method according to the invention.

By making use of a layer of organic material 2 covering the inorganic material 1 to be patterned, the problem that it is difficult to have a good selectivity towards the (inorganic) hard masks, i.e. the upper mask layer 4 and lower mask layer 3, is solved. Such selectivity is difficult to achieve with only an inorganic dielectric material. By using the layer of organic material 2, it is possible to first etch the organic material to the small dimension making use of the method according to the invention and then use the organic material 2 as a mask for etching the inorganic material 1.

The creation of a pattern with smaller dimensions in a resist in general requires a sufficiently thin resist layer to avoid problems caused by collapse of the remaining resist material. As a general rule known in the art, the thickness of the resist is not allowed to be more than three times a critical, i.e. minimum, dimension of a structure to be created. By making use of the layer of organic material covering the inorganic material and creating the desired pattern (i.e. the pattern resulting from the first pattern in combination with the second pattern) in the organic material, a better mechanical stability can be achieved as an organic material can be selected having good mechanical stability properties.

Thus, by creating a second pattern which is identical to the first pattern but displaced over a distance with respect to the first pattern, removing a part of the mask layers in accordance with at least the second pattern and removing a part of the material in accordance with a mask formed by remaining parts of the lower and upper mask layers, structures can be created with smaller dimensions than the resolution of the pattern itself, i.e. the resolution determined e.g. by an imaging system for applying the pattern on the layers. Hence, with less advanced steppers and resist systems, structures having a smaller dimension such as smaller transistor gates can be created.

## Claims

1. A method of manufacturing a semiconductor device wherein a pattern is created in an inorganic dielectric (1) formed upon a substrate (7), the method comprising:
- providing a layer of organic material (2) on top of the inorganic dielectric (1);
- covering the layer of organic material (2) with a lower mask layer (3) and covering the lower mask layer (3) with an upper mask layer (4);
- creating a first pattern in a layer of resist (5) on the upper mask layer (4) by means of a lithographic mask;
- etching the first pattern into the upper mask layer (4) by using an etch recipe that is selective towards the lower mask layer (3);
- removing the said layer of resist (5);
- providing a new layer of resist (6);
- creating, by means of the lithographic mask, a second pattern in the new layer of resist (6) on the upper mask layer (4), where present, and on the lower mask layer (3) at locations where the upper mask layer (4) has been removed, the second pattern being displaced over a distance with respect to the first pattern;
- creating trenches (3a) in the lower mask layer (3) by etching the lower mask layer (3) with an etch recipe that is selective towards the upper mask layer (4), the trenches (3a) having a width that consists only of the overlapping exposed parts of the first pattern and the second pattern;
- etching the layer of organic material (2), thereby also removing the resist (6), therewith creating trenches in the layer of organic material with same dimensions as the trenches (3a) in the lower mask layer (3), said trenches together defining the said pattern;
- etching the pattern present in the layer of organic material (2) into the inorganic dielectric (1), and
- removing the upper and lower mask layers (3,4) and the layer of organic material (2).

2. A method of manufacturing a semiconductor device wherein a pattern is created in an inorganic dielectric (1) formed upon a substrate (7), the method comprising:
- providing a layer of organic material (2) on top of the inorganic dielectric (1);
- covering the layer of organic material (2) with a lower mask layer (3) and covering the lower mask layer (3) with an upper mask layer (4);
- creating a first pattern in a layer of resist (5) on the upper mask layer (4) by means of a lithographic mask;
- etching the first pattern into the upper mask layer (4) by using an etch recipe that is selective towards the lower mask layer (3);
- removing the said layer of resist (5);
- providing a new layer of resist (6);
- creating, by means of the lithographic mask, a second pattern in the new layer of resist (6) on the upper mask layer (4), where present, and on the lower mask layer (3) at locations where the upper mask layer (4) has been removed, the second pattern being displaced over a distance with respect to the first pattern;
- selectively etching the upper mask layer (4) with the second pattern as formed in the resist (6), resulting in a spacing with a dimension smaller than a dimension obtainable with the resolution of the first pattern and the second pattern, the resist (6) being removed subsequently;
- selectively etching the lower mask layer (3) without affecting the upper mask layer (4), the lower mask layer therewith being provided with the pattern;
- etching the layer of organic material (2), wherein the pattern present in the lower mask layer (3) and/or the upper mask layer (4) is used as a mask;
- etching the inorganic dielectric (1), wherein the pattern present in the layer of organic material (2) is used as a mask, and simultaneously etching the lower mask layer (3) and the upper mask layer (4), and
- removing the layer of organic material (2).

## Patentansprüche

1. Verfahren vom Herstellen einer Halbleitervorrichtung, wobei ein Muster in einem, über einer Trägerschicht (7) gebildeten, anorganischen Dielektrikum (1) geschaffen wird, wobei das Verfahren umfasst:
- Bereitstellen einer Schicht organischen Materials (2) auf dem anorganischen Dielektrikum (1);
- Bedecken der Schicht organischen Materials (2) mit einer unteren Maskenschicht (3) und Bedecken der unteren Maskenschicht (3) mit einer oberen Maskenschicht (4);
- Schaffen eines ersten Musters in einer Fotolackschicht (5) auf der oberen Maskenschicht (4) mittels einer lithographischen Maske;
- Ätzen des ersten Musters in die obere Maskenschicht (4) durch Verwenden einer Ätzrezeptur, welche gegenüber der unteren Maskenschicht (3) selektiv ist;
- Entfernen der Fotolackschicht (5);
- Bereitstellen einer neuen Fotolackschicht (6);
- Schaffen, mittels der lithographischen Maske, eines zweiten Musters in der neuen Fotolackschicht (6) auf der oberen Maskenmaske (4), wo vorhanden, und auf der unteren Maskenschicht (3), in Bereichen wo die obere Maskenschicht (4) entfernt wurde, wobei das zweite Muster in Bezug auf das erste Muster über eine Distanz verschoben wird;
- Schaffen von Gräben (3a) in der unteren Maskenschicht (3) durch Ätzen der unteren Maskenschicht (3) mit einer Ätzrezeptur, welche gegenüber der oberen Maskenschicht (4) selektiv ist, wobei die Gräben (3a) eine Breite haben, welche nur aus den überschneidenden freiliegenden Teilen des ersten Musters und zweiten Musters besteht;
- Ätzen der Schicht organischen Materials (2), wodurch auch der Fotolack (6) entfernt wird, wobei Gräben in der Schicht organischen Materials mit gleichen Abmessungen wie die Gräben (3a) in der unteren Maskenschicht (3) geschaffen werden, wobei die Gräben gemeinsam das Muster festlegen;
- Ätzen des Musters, das in der Schicht organischen Materials (2) vorhanden, in das anorganische Dielektrikum (1) und
- Entfernen der oberen und unteren Maskenschichten (3,4) und der Schicht organischen Materials (2).

2. Verfahren vom Herstellen einer Halbleitervorrichtung, wobei ein Muster in einem anorganischen, auf einer Trägerschicht (7) gebildeten, Dielektrikum (1) geschaffen wird, wobei das Verfahren umfasst:
- Bereitstellen einer Schicht organischen Materials (2) auf dem anorganischen Dielektrikum (1);
- Bedecken der Schicht organischen Materials (2) mit einer unteren Maskenschicht (3) und Bedecken der unteren Maskenschicht (3) mit einer oberen Maskenschicht (4);
- Schaffen eines ersten Musters in einer Fotolackschicht (5) auf der oberen Maskenschicht (4) mittels einer lithographischen Maske;
- Ätzen des ersten Musters in die obere Maskenschicht (4) durch Verwenden einer Ätzrezeptur, welche gegenüber der unteren Maskenschicht (3) selektiv ist;
- Entfernen der Fotolackschicht (5);
- Bereitstellen einer neuen Fotolackschicht (6);
- Schaffen, mittels der lithographischen Maske, eines zweiten Musters in der neuen Fotolackschicht (6) auf der oberen Maskenschicht (4), wo vorhanden, und auf der unteren Maskenschicht (3), in Bereichen wo die obere Maskenschicht (4) entfernt wurde, wobei das zweite Muster in Bezug auf das erste Muster über eine Distanz verschoben wird;
- selektives Ätzen der oberen Maskenschicht (4) mit dem zweiten Muster, wie in dem Fotolack (6) gebildet, was zu einem Abstand mit einer kleineren Abmessung als eine Abmessung führt, die durch die Auflösung des ersten Musters und des zweiten Musters erreichbar ist, wobei der Fotolack (6) anschließend entfernt wird;
- selektives Ätzen der unteren Maskenschicht (3) ohne die obere Maskenschicht (4) zu beeinträchtigen, wodurch die untere Maskenschicht mit dem Muster versehen wird;
- Ätzen der Schicht organischen Materials (2), wobei das in der unteren Maskenschicht (3) und/oder oberen Maskenschicht (4) vorhandene Muster als eine Maske verwendet wird;
- Ätzen des anorganischen Dielektrikums (1), wobei das in der Schicht organischen Materials (2) vorhandene Muster als eine Maske verwendet wird, und zeitgleiches Ätzen des unteren Maskenschicht (3) und der oberen Maskenschicht (4), und
- Entfernen der Schicht organischen Materials (2).

## Revendications

1. Une méthode de fabrication d'un dispositif semiconducteur dans laquelle un motif est créé dans un diélectrique inorganique (1) formé sur un substrat (7), la méthode comprenant de:
- fournir une couche de matériau organique (2) au-dessus du diélectrique inorganique (1);
- couvrir la couche de matériau inorganique (2) avec une couche de masquage inférieure (3) et couvrir la couche de masquage inférieure (3) avec une couche de masquage supérieure (4);
- créer un premier motif dans une couche de résist (5) sur la couche de masquage supérieure (4) au moyen d'un masque lithographique;
- graver le premier motif dans la couche de masquage supérieure (4) en utilisant une recette de gravure qui est sélective vis-à-vis de la couche de masquage inférieure (3);
- éliminer ladite couche de résist (5);
- fournir une nouvelle couche de résist (6)
- créer, au moyen d'un masque lithographique, un second motif dans la nouvelle couche de résist (6) sur la couche de masquage supérieure (4), si elle est présente, et sur la couche de masquage inférieure (3) aux endroits où la couche de masquage supérieure (4) a été éliminée, le second motif étant déplacé d'une distance par rapport au premier motif;
- créer des tranchées (3a) dans la couche de masquage inférieure (3) en gravant la couche de masquage inférieure (3) avec une recette de gravure qui est sélective vis-à-vis de la couche de masquage supérieure (4), les tranchées (3a) ayant une largeur qui est constituée seulement des parties se chevauchant du premier motif et du second motif;
- graver la couche de matériau organique (2), ce qui élimine aussi la résist (6), afin de créer des tranchées dans la couche de matériau organique avec les mêmes dimensions que les tranchées (3a) dans la couche de masquage inférieure (3), lesdites tranchées définissant ensemble ledit motif;
- graver le motif présent dans la couche de matériau organique (2) dans le diélectrique inorganique (1), et
- éliminer les couches de masquage supérieure et inférieure (3, 4) et la couche de matériau organique (2).

2. Une méthode de fabrication d'un dispositif semiconducteur dans laquelle un motif est créé dans un diélectrique inorganique (1) formé sur un substrat (7), la méthode comprenant de:
- fournir une couche de matériau organique (2) au-dessus du diélectrique inorganique (1);
- couvrir la couche de matériau inorganique (2) avec une couche de masquage inférieure (3) et couvrir la couche de masquage inférieure (3) avec une couche de masquage supérieure (4);
- créer un premier motif dans une couche de résist (5) sur la couche de masquage supérieure (4) au moyen d'un masque lithographique;
- graver le premier motif dans la couche de masquage supérieure (4) en utilisant une recette de gravure qui est sélective vis-à-vis de la couche de masquage inférieure (3);
- éliminer ladite couche de résist (5);
- fournir une nouvelle couche de résist (6);
- créer, au moyen d'un masque lithographique, un second motif dans la nouvelle couche de résist (6) sur la couche de masquage supérieure (4), si elle est présente, et sur la couche de masquage inférieure (3) aux endroits où la couche de masquage supérieure (4) a été éliminée, le second motif étant déplacé d'une distance par rapport au premier motif;
- graver de manière sélective la couche de masquage supérieure (4) avec le second motif tel que formé dans la résist (6), résultant en un espacement avec une dimension plus petite qu'une dimension pouvant être obtenue avec la résolution du premier motif et du second motif, la résist (6) étant éliminée ultérieurement;
- graver de manière sélective la couche de masquage inférieure (3) sans affecter la couche de masquage supérieure (4), la couche de masquage inférieure comportant ainsi le motif;
- graver la couche de matériau organique (2), dans laquelle le motif présent dans la couche de masquage inférieure (3) et/ou la couche de masquage supérieure (4) est utilisée comme un masque;
- graver le diélectrique inorganique (1), dans laquelle le motif présent dans la couche de matériau organique (2) est utilisé comme un masque, et graver simultanément la couche de masquage inférieure (3) et la couche de masquage supérieure (4), et
- éliminer la couche de matériau organique (2).
